# EUROPEAN PATENT APPLICATION

(11) **EP 3 674 536 A1**
(43) Date of publication of application: **01.07.2020**
(21) Application number: 19217726.9
(22) Date of filing: 18.12.2019
(51) Int. Cl.: F02D 41/20

(54) **METHOD OF CONTROLLING INJECTOR DRIVING CIRCUIT**

(30) Priority: 25.12.2018 JP 2018240845
(71) Applicant: Nikki Co., Ltd., Kanagawa-ken 243-0801 (JP)
(72) Inventor: YAMADA, Takahiro, Atsugi, Kanagawa 243-0801 (JP); INO, Takuya, Atsugi, Kanagawa 243-0801 (JP)
(74) Representative: Boult Wade Tennant LLP

(57) **Abstract**

A second field effect transistor (FET) is first turned OFF in an OFF state, and then a first FET is turned OFF after a predetermined time elapses, thereby preventing damage to a Zener diode due to a back electromotive voltage from an injector generated when a valve is closed.

## Description

### BACKGROUND

### Technical Field

The present invention relates to a method of controlling an injector (fuel injection valve) driving circuit that injects a gas fuel into each cylinder, for example, in a gas fuel engine of LPG, CNG, etc.

### Related Art

An injector used for a gas fuel engine of LPG, CNG, etc. needs to inject a large amount of fuel such as natural gas fuel in a short period of time. An injector driving circuit is configured to supply a starting current of a value set in advance at a beginning of a valve opening time to the injector for a set time, and then pulse width modulation (PWM)-control a holding current having a value greater than or equal to a value necessary to retain an open valve state to supply the holding current to the injector. For example, the above description is disclosed in JP 63-35827 B, JP 8-144859 A, JP 11-294262 A, etc.

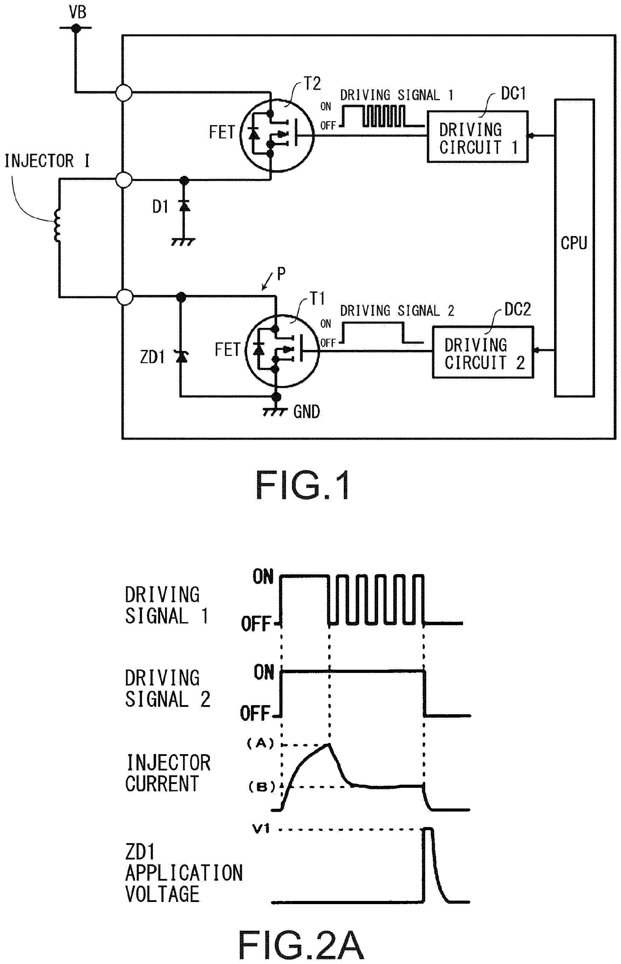

FIG. 1 illustrates a main part of the conventional injector driving circuit, and an injector I opened and closed by a solenoid coil, etc. includes a first field effect transistor (FET) T1 and a second FET T2, which are switching elements that open and close a flow of a driving current to a driving mechanism such as a solenoid coil of the injector I through a first driving circuit DC1 and a second driving circuit DC2 according to a command from a CPU turned ON via a power ON position.

Further, when the power is turned ON by an engine start operation, a valve opening signal is sent to the first driving circuit DC1 and the second driving circuit DC2 by a valve opening command signal from the CPU, and each of the first FET T1 and the second FET T2 is turned ON.

In this instance, as illustrated in FIG. 2A, the first FET T1 is in an ON state from a valve opening timing to a valve closing timing, and the second FET T2 is turned ON by supplying a current (A) as an injector current at first to obtain valve opening torque at the valve opening timing in synchronization with the first FET T1. Thereafter, an opening operation holding current of the injector I by PWM control is formed so that the injector current becomes a current (B) which is a valve opening holding current of the injector I.

In addition, at the valve closing timing, both the first FET T1 and the second FET T2 are simultaneously turned OFF to shut off the injector current and close the injector I. A Zener diode ZD1 having a rated voltage V1 of a voltage value in accordance with the injector current (B) illustrated in FIG. 2A is included to perform a closing operation in a short time at the valve closing time and prevent damage to the FET T1 which occurs since a back electromotive voltage due to the solenoid coil of the injector I, etc. exceeds a maximum voltage between a drain and a source of the FET T1 (position P illustrated in FIG. 1) .

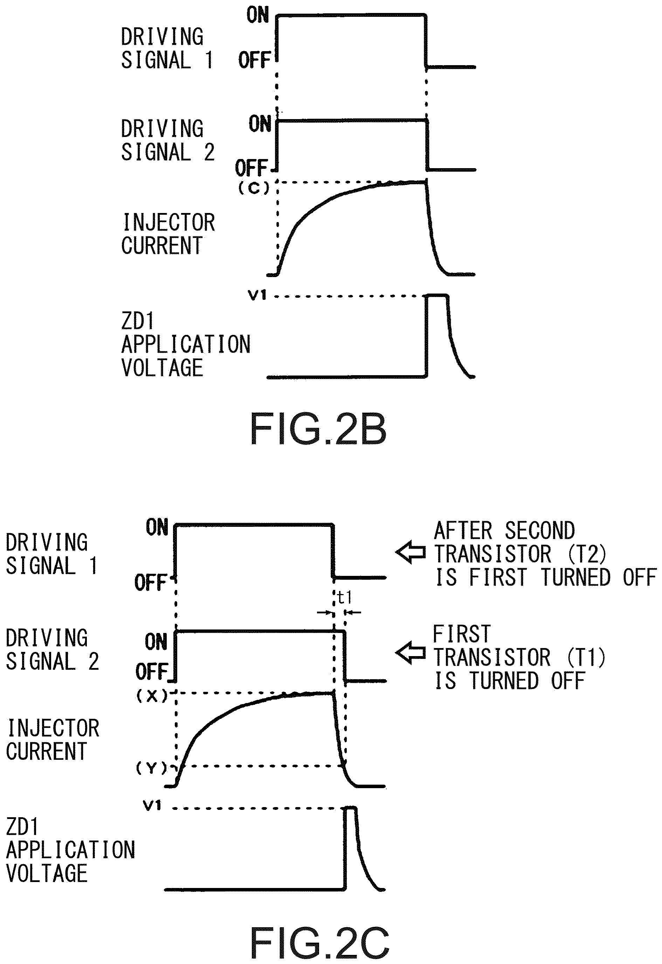

Incidentally, for example, in a natural gas fuel vehicle, due to the fact that water contained in methane gas in natural gas, moisture generated at the time of combustion, etc. freezes at low temperature, or when a valve of the injector is formed of rubber, etc., the valve of the injector sticks due to sticking, etc. of rubber, even when a starting current of a value set in advance at the beginning of the valve opening time is supplied for a set time, the valve of the injector is difficult to open, and there is a problem that engine startability deteriorates. In response thereto, to make an improvement by increasing the injector valve opening torque, during cold start or when the injector valve sticks, as illustrated in FIG. 2B, the valve opening torque is increased by turning ON both the first FET T1 and the second FET T2 during injection to set the injector current to a maximum current (C).

### SUMMARY

However, in a conventional method of controlling the injector driving circuit, the back electromotive voltage generated by the injector I in an OFF state becomes a voltage V1 clamped to a Zener voltage value of a Zener diode ZD1 as illustrated in FIG. 2A. However, in an improvement control method during cold start or when the injector valve sticks, PMW control as illustrated in FIG. 2A is not performed, and a maximum injector current (C) flows with respect to the resistance of the injector I as illustrated in FIG. 2B.

When a specified time is reached, a driving signal 1 and a driving signal 2 are turned OFF, the first FET T1 and the second FET T2 are turned OFF, and the amount of energy consumed by the back electromotive voltage V1 due to the solenoid coil of the injector I, etc. increases in proportion to the square of the current value. Thus, there is a problem that the Zener diode ZD1 is damaged, and it is necessary to increase the capacity of the Zener diode ZD1. However, when the capacity is increased, a shape increases in size, requiring installation space. Further, there is a problem that a part price is increased.

The invention has been made to solve the above problems, and an object of the invention is to provide a method of controlling an injector driving circuit capable of preventing damage to the Zener diode ZD1 for reducing electromotive force energy due to the injector in an OFF state even when valve opening torque is increased by turning ON both the first FET T1 and the second FET T2 to obtain the maximum injector current (C) during cold start or when the injector valve sticks in the injector driving circuit using a part according to a conventional standard.

A method of controlling an injector driving circuit which is the invention conceived to solve the above problems is a method of controlling an injector driving circuit including a first field effect transistor (FET) which is a switching element that opens and closes a driving power supply to an injector, a second FET having a PWM control function for supplying a starting current of a value set in advance at a beginning of a valve opening time to the injector for a set time in synchronization with the first FET when the first FET is in an ON state to open a valve in a short time and then supplying a driving current for maintaining opening having a value greater than or equal to a value necessary to maintain an opening or closing driving state to the injector, and a Zener diode for protecting the first FET from a back electromotive voltage generated from a coil of the injector when the first FET is turned OFF, in which valve opening torque is increased to open the injector by turning ON both the first FET and the second FET to obtain a maximum current during cold start or when an injector valve sticks, the second FET is turned OFF at first when the injector is closed thereafter, and then damage to the Zener diode due to a back electromotive voltage from the injector generated when the valve is closed is prevented by turning OFF the first FET after a predetermined time elapses.

In addition, in the invention, it is preferable that a predetermined time for turning OFF the second FET and then turning OFF the first FET is a time when a back electromotive voltage from the coil of the injector is consumed by the first FET in an ON state and becomes lower than a voltage value of the Zener diode after at least the second FET is turned OFF.

According to the invention, it is possible to prevent an increase in size of a component and an increase in price by preventing damage to a Zener diode for reducing electromotive force energy due to an injector in an OFF state even when valve opening torque is increased by turning ON both a first FET and a second FET to obtain a maximum current during cold start or when an injector valve sticks in an injector driving circuit using a part according to a conventional standard.

### BRIEF DESCRIPTION OF DRAWINGS

FIG. 1 is a circuit diagram illustrating a main part of an injector driving circuit of a preferable embodiment of the invention and a conventional example; and
FIGS. 2A, 2B, and 2C illustrate waveform flowcharts of control signals in the embodiment and the conventional example illustrated in FIG. 1, in which FIG. 2A corresponds to a normal time, FIG. 2B corresponds to a time when a vehicle is cold or when a valve sticks in the conventional example, and FIG. 2C corresponds to a time when a vehicle is cold or when a valve sticks in the present embodiment illustrated in FIG. 1.

### DETAILED DESCRIPTION

Next, an embodiment of the invention will be described with reference to drawings.

FIG. 1 is a circuit diagram illustrating a main part of an injector driving circuit used for carrying out a control method by the invention, and the invention can prevent an increase in size of a component and an increase in price by preventing damage to a Zener diode for reducing back electromotive voltage energy due to the injector in an OFF state even when a conventional component is used, which is basically in common with a conventional driving circuit.

In addition, the control method is the same as that in the conventional example in a normal time, and a detailed description thereof is omitted.

In addition, the present embodiment is similar to the conventional control method illustrated in FIG. 2B in that valve opening torque is increased to open an injector by turning ON both the first FET T1 and the second FET T2 in an ON state to obtain a maximum current when a vehicle is cold or a valve sticks.

Further, the control method according to the present embodiment first turns OFF the second FET T2 in an OFF state, and then turns OFF the first FET T1 after a predetermined time elapses, thereby preventing damage to the Zener diode ZD1 due to a back electromotive voltage from the injector I generated when a valve is closed.

Furthermore, a detailed description will be given based on FIG. 1 and FIG. 2C. When the vehicle is cold or when the valve sticks, a driving signal 1 and a driving signal 2 from a first driving circuit DC1 and a second driving circuit DC2 are transmitted to the first FET T1 and the second FET T2 by a command from the CPU to turn ON both the transistors, so that a maximum injector current (X) (the same as the injector current (C) of FIG. 2B) flows to the injector I, thereby increasing the valve opening torque to open the injector I. After a specified time is reached, unlike conventional control by driving signals from the first driving circuit DC1 and the second driving circuit DC2 by a command from the CPU for simultaneously turning OFF both the first FET T1 and the second FET T2 illustrated in FIG. 2B, the second FET T2 is first turned OFF by the driving signal 1 in an OFF state, and then the first FET T1 is turned OFF by the driving signal 2 after a predetermined time t1 elapses.

In this instance, even when a back electromotive voltage generated in the injector I is consumed by the first FET T1 in an ON state after at least the second FET T2 is turned OFF, so that an injector current (Y) decreases, and then the first FET T1 is turned OFF, it is possible to prevent damage to the Zener diode ZD1 by a back electromotive voltage V1 from the injector I generated when the valve is closed.

As described above, according to the present embodiment, it is possible to prevent components (FET and Zener diode (ZD1)) from being damaged even when a control operation is performed such that valve opening torque is increased by having a maximum current in an ON state to open the injector when the vehicle is cold or when the valve sticks using a component and a driving circuit similar to the conventional injector driving circuit.

## Claims

1. A method of controlling an injector driving circuit including a first field effect transistor (FET) which is a switching element that opens and closes a driving power supply to an injector, a second FET having a PWM control function for supplying a starting current of a value set in advance at a beginning of a valve opening time to the injector for a set time in synchronization with the first FET when the first FET is in an ON state to open a valve in a short time and then supplying a driving current for maintaining opening having a value greater than or equal to a value necessary to maintain an opening or closing driving state to the injector, and a Zener diode for protecting the first FET from a back electromotive voltage generated from a coil of the injector when the first FET is turned OFF,
wherein valve opening torque is increased to open the injector by turning ON both the first FET and the second FET to obtain a maximum current during cold start or when an injector valve sticks, the second FET is turned OFF at first when the injector is closed thereafter, and then damage to the Zener diode due to a back electromotive voltage from the injector generated when the valve is closed is prevented by turning OFF the first FET after a predetermined time elapses.

2. The method of controlling an injector driving circuit according to claim 1, wherein a predetermined time for turning OFF the second FET and then turning OFF the first FET is a time when a back electromotive voltage from the coil of the injector is consumed by the first FET in an ON state and becomes lower than a voltage value of the Zener diode after at least the second FET is turned OFF.
